# EUROPÄISCHE PATENTSCHRIFT

(11) **EP 3 857 246 B1**
(45) Veröffentlichungstag und Bekanntmachung des Hinweises auf die Patenterteilung: **22.10.2025**
(21) Anmeldenummer: 19817945.9
(22) Anmeldetag: 02.11.2019
(51) Int. Cl.: G01R 31/58, G01N 27/20

(54) **VERFAHREN ZUR ELEKTRISCHEN MESSUNG UND VERWENDUNG EINER MESSTECHNIK ZUR BESTIMMUNG DES VERSCHLEISSZUSTANDES VON ELEKTRISCHEN LEITUNGEN, SOWIE KABELVERSCHLEISSZUSTANDSMESSVORRICHTUNG**
METHOD FOR ELECTRICAL MEASUREMENT AND USE OF MEASUREMENT TECHNOLOGY TO DETERMINE THE STATE OF WEAR OF ELECTRICAL LINES, AND DEVICE FOR MEASURING A CABLE STATE OF WEAR
PROCÉDÉ DE MESURE ÉLECTRIQUE ET UTILISATION D'UNE TECHNIQUE DE MESURE POUR LA DÉTERMINATION DE L'ÉTAT D'USURE DE LIGNES ÉLECTRIQUES, AINSI QUE DISPOSITIF DE MESURE D'ÉTAT D'USURE DE CÂBLES

(30) Priorität: 02.11.2018 DE 102018127444; 07.11.2018 DE 102018008724
(43) Veröffentlichungstag der Anmeldung: 04.08.2021
(73) Patentinhaber: Klaus Faber AG, 66113 Saarbrücken (DE)
(72) Erfinder: WITTMANN, Armin, 54298 Welschbillig (DE); EHLENZ, Tobias, 54612 Lasel (DE)
(74) Vertreter: Patentanwälte Bernhardt / Wolff Partnerschaft mbB
(86) Internationale Anmeldenummer: PCT/DE2019/100939
(87) Internationale Veröffentlichungsnummer: WO 2020/088716

(56) Entgegenhaltungen:
- DE-A1- 102013 008 968
- DE-A1- 4 119 655
- JP-A- H0 458 407
- JP-B2- 5 925 961
- US-B1- 6 242 924
- US-B2- 7 012 197
- KUMAR SOMESH ET AL: "Performance modeling and broadband characterization of chip-to-chip interconnects with rough surfaces", 2016 IEEE 18TH ELECTRONICS PACKAGING TECHNOLOGY CONFERENCE (EPTC), IEEE, 30 November 2016 (2016-11-30), pages 629 - 632, XP033067565, DOI: 10.1109/EPTC.2016.7861556

## Beschreibung

Die Erfindung betrifft ein Verfahren zur elektrischen Messung des Verschleißzustandes von elektrischen Leitungen, insbesondere des mechanischen Verschleißzustands von isolierten elektrischen Leitern, wie im Oberbegriff des Anspruches 1 angegeben. Außerdem betrifft die Erfindung eine Vorrichtung nach Anspruch 7 und eine Verwendung eines Messgeräts nach Anspruch 10.

Elektrokabel werden vielfältig in stationären und mobilen Installationen wie beispielsweise Maschinen, Anlagen, Gebäuden und Geräten verwendet. In vielen Einbausituationen sind Elektrokabel teils erheblichen dynamischen Belastungen ausgesetzt, die einen mechanischen Verschleiß und damit letztendlich ein Versagen dieser elektrischen Leitung verursachen.

Aber nicht nur mechanischer Verschleiß ist problematisch, sondern auch Umwelteinflüsse, Ermüdung von Isolierungen durch Alterung oder Verschleiß durch die reguläre oder besondere Beanspruchung als Strom- und/oder Signalleitungskabel.

Der Ausfall eines Kabels hat in aller Regel eine Fehlfunktion der betroffenen Installation zur Folge. Fehlfunktionen verursachen durch notwendige Reparaturen und ggf. auch durch Nutzungsausfälle oftmals beträchtliche Kosten. Sind sicherheitsrelevante Installationen betroffen, können Fehlfunktionen unter Umständen eine Gefahr für Leib und Leben darstellen.

Es besteht also ein erhebliches Interesse, den Zustand von Kabeln in-situ zu prüfen, und anhand des so feststellbaren Verschleißfortschrittes die zu erwartende Restnutzungsdauer und ggf. einen Austauschzeitpunkt für das betreffende Kabel bestimmen zu können.

Bekannte Überprüfungsverfahren von elektrischen Leitungen werden üblicherweise nach Kabelprüfung und Kabeldiagnose unterschieden.

Die Kabelprüfung dient zur Bestimmung einer Funktionsfähigkeit des zu prüfenden Elektrokabels. Zur Kabelprüfung kann beispielsweise die zerstörungsfreie VLF-Prüftechnik (Very Low Frequency), wie in DE 44 37 355 C2 und DE 44 13 585 C2 gelehrt, angewendet werden.

Die konventionelle Kabeldiagnose bestimmt einen momentanen Kabelzustand, insbesondere einen Alterungszustand. Gängige zerstörungsfreie Diagnoseverfahren sind beispielsweise das in der DE 10 2013 008 968 A1 erwähnte OWTS- und das in der DE 10 2015 202 597 B4 erläuterte Tan-Delta-Verfahren. Die OWTS-Technologie (OWTS = Oscillating Wave Test System) und das Tan-Delta-Verfahren ermöglichen ein einfaches Erkennen und Lokalisieren sowohl von alterungsbedingten Schwachstellen als auch von Beschädigungen des Elektrokabels, teilweise ausschließlich für Mittelspannung.

Eine Gemeinsamkeit der bekannten Prüf- und Diagnoseverfahren besteht darin, lediglich den Zustand der Isolierung(en) des Prüflings festzustellen. Der Verschleißgrad des stromführenden Teils eines Elektrokabels wird nur sekundär anhand des Zustandes der Isolierung abgeleitet. Eine Prognose zur weiteren Nutzungsdauer des Elektrokabels orientiert sich am festgestellten Zustand der Isolierung(en).

Verschleißt der elektrische Leiter im Inneren eines Elektrokabels, beispielsweise aufgrund dynamischer mechanischer Belastungen, schneller als die umgebende Isolierung, kann der Versagenszeitpunkt bzw. die Restnutzungsdauer mit den beschriebenen Prüf- und Diagnoseverfahren nicht sicher erkannt werden.

Aus US 6,242,924 B1 ist bekannt, dass Lunker in elektrischen Leiterbahnen elektronisch detektierbar sind, um eine Qualitätssicherung in der Fabrikation von Computerchips zu automatisieren. Auf den Chips sind schichtweise aufeinander angeordnete Leiterbahnen erst dann für den weiteren Fabrikationsprozess zugelassen, wenn eine ausreichende Stromdurchgängigkeit prüfbar war. Es wird ein Skineffekt genutzt, um Fertigungsfehler zu detektieren, welche einmalig im Lebenszyklus der geprüften Leiterbahn bei deren Herstellungsprozess entstanden sind. Veränderungen im Verlauf der Nutzung sind nicht thematisiert, ebenso nicht eine elektronische Beurteilung von Kabeln.

Ausgehend von den aufgezeigten Prüf- und Diagnoseverfahren für Kabel liegt der vorliegenden Erfindung die Aufgabe zugrunde, eine Vorrichtung und ein Verfahren vorzuschlagen, das eine wirtschaftlich sinnvolle und sichere Bestimmung des Verschleißzustandes von Kabeln ermöglicht.

Diese Aufgabe ist erfindungsgemäß gelöst durch ein Kabelverschleißzustandsmessverfahren nach Anspruch 1, umfassend dessen kennzeichnende Merkmale. Unter der Nutzung eines Skineffektes wird im Rahmen der Erfindung beispielsweise die Oberflächenrauheit der elektrischen Leitungen bzw. des elektrischen Leiters eines Elektrokabels erfasst. Anhand festgestellter Rauheitswerte wird bei diesem bevorzugten Ausführungsbeispiel ein Verschleißgrad des geprüften Leitermaterials bestimmt. Die Aufgabe ist ebenfalls gelöst durch eine Kabelverschleißzustandsmessvorrichtung nach Anspruch 7 oder durch eine erfindungsgemäße Verwendung eines Messgeräts nach Anspruch 10 Vorteilhafte Ausführungsformen sind Gegenstand von jeweiligen Unteransprüchen.

Trotz Schutz durch Isolierung und trotz weicher Materialien verändert sich den der Erfindung zugrundeliegenden Untersuchungen zufolge unter dynamischer mechanischer Belastung die Oberflächenrauheit von metallischen Leitungen erheblich. Die Erfindung nutzt dies zur Bestimmung des Verschleißes. Die elektrischen Leiter von Elektrokabeln zeigten diesen Effekt mitunter deutlich und über einen Zeitraum mechanischer Beanspruchung nachvollziehbar zunehmend. Als besonders relevant zur Beurteilung des Verschleißgrades bzw. zur Prognose einer Restnutzungsdauer erkennt die Erfindung mittlere Rautiefen in einem Bereich von bis zu 2 µm. Wiesen elektrische Leiter beanspruchter Kabel mittlere Rautiefen von 2 µm auf, konnte eine Restnutzungsdauer nach vorliegenden Erkenntnissen noch auf 10 % bis 20 %, der betreffende elektrische Leiter als austauschreif eingeordnet werden. Techniker nennen ein derart beanspruchtes Kabel, dass zum Risiko geworden ist, ablegereif.

Der bekannte Skineffekt führt dazu, dass sich Ströme auf Oberflächen von elektrischen Leitern konzentrieren. Er tritt bei elektrischen Leitern auf, die von höherfrequenten Wechselströmen durchflossen werden. Die Stromdichte eines Leiters nimmt mit steigender Frequenz im Inneren des Leiters im Vergleich zum Randbereich ab. Der Skineffekt kommt durch auftretende Wirbelströme zustande, welche die Eindringtiefe von magnetischen Wechselfeldern begrenzen. Die Widerstandswerte der Leiter sind somit frequenzabhängig und hängen u.a. von der Amplitude des magnetischen Feldes und den Materialeigenschaften des Leiters ab.

Erfindungsgemäß wird generell zur Verschleißmessung, egal ob mechanische Belastungen oder Nutzungsbelastungen ohne äußere Einflüsse stattgefunden haben, bevorzugt ein Signal in Form eines höherfrequenten Wechselstroms in den oder die elektrischen Leiter eines zu untersuchenden Elektrokabels eingeleitet. Durch den Skineffekt konzentriert sich der Stromfluss auf die Oberflächen des zu untersuchenden elektrischen Leiters. Die Eindringtiefe der magnetischen Wechselfelder wird als Skintiefe bezeichnet und ist abhängig von der Frequenz des eingeleiteten Signals.

In einer bevorzugten Ausführungsform wird ein Impedanzmessgerät und ein elektrisches Messsignal mit einer Frequenz zwischen 800 und 1000 MHz verwendet. In diesem Frequenzbereich fließen beispielsweise die elektrischen Ströme mit einer Skintiefe von ca. 2 µm an der Oberfläche des elektrischen Leiters entlang und decken damit einen relevanten Bereich zur erfindungsgemäßen Erfassung der Oberflächeneigenschaften, insbesondere der von der Erfindung bisher besonders ausgewerteten Oberflächenrauheit, ab. Die Beschreibung des Messsignals, insbesondere die Nennung des Frequenzbereichs von 800 bis 1000 MHz und der Skintiefe 2 µm, stellen keine Einschränkung der Erfindung dar, sondern beschreiben lediglich eine bevorzugte Ausführungsform.

Mit während der Kabellebensdauer zunehmender Oberflächenrauheit ihrer Leiter steigt den der Erfindung zugrundeliegenden Untersuchungen zufolge der Widerstandswert des durchflossenen Bereiches; entsprechend verändert sich der erfasste Verschleißmesswert.

Bei der durch die Erfindung ermöglichten Überwachung von Standardkabeln, also solchen Elektrokabeln die nicht mit besonderen zusätzlichen Prüfleitern bestückt sind, werden mittels des erfindungsgemäßen Verfahrens ermittelte Messwerte vorzugsweise in einem weitgehend permanenten Monitoring erfasst und mit Referenzmesswerten verglichen. Die Referenzmesswerte bilden dabei einen Signalverlauf über die gesamte Lebensdauer eines Elektrokabels ab. Ein Vergleich des Signalverlaufs des überwachten Elektrokabels mit einem Referenz-Signalverlauf ergibt die gewünschten Rückschlüsse auf den Verschleißgrad, die Verschleißgeschwindigkeit und die zu erwartende Restnutzungsdauer.

In einer weiteren bevorzugten Ausführungsform des erfindungsgemäßen Verfahrens, insbesondere anwendbar bei Elektrokabeln mit integrierten Prüfleitern, wird anstelle eines permanenten Monitorings, in frei definierbaren zeitlichen Abständen, beispielsweise monatlich, eine Kabeldiagnose vorgenommen. Der Prüfling wird hierbei für wenige Sekunden mit dem erfindungsgemäßen Diagnose-Signal beaufschlagt und gleichzeitig der Widerstandswert bzw. die Dämpfung des Elektrokabels gemessen. Das Messergebnis wird bei diesem Verfahren mit einem Referenzwert abgeglichen, wie er bei der Beaufschlagung eines fabrikneuen beschädigungsfreien Elektrokabels gleicher Bauart und Länge entstehen würde. Die Ermittlung des Referenzwertes erfolgt hierbei entweder durch eine Messung unmittelbar nach der Installation eines neuen Elektrokabels oder durch eine Berechnung, wenn nur eine Simulation den Startwert ermittelbar macht, weil beispielsweise kein abgelegtes Muster oder kein Datenblatt verfügbar ist.

Sowohl ein permanentes Monitoring als auch Stichprobendiagnosen in zeitlichen Intervallen können mittels erfindungsgemäßer Verfahren während des laufenden Betriebes erfolgen. Ein Abschalten der zu prüfenden Leitung ist nicht erforderlich.

Das erfindungsgemäße Verfahren arbeitet zerstörungsfrei, die Stromstärke des Prüf- bzw. Diagnosesignals bewegt sich im Milliampere-Bereich.

Das erfindungsgemäße Verfahren kann bei allen gängigen Elektrokabeln mit metallischen Leitern angewendet werden. Davon umfasst sind insbesondere Energie- und Datenleitungen, sowohl mit starren metallischen elektrischen Leitern als auch mit metallischen elektrischen Leitern in Litzenform.

Eine Vorrichtung zur Durchführung der erfindungsgemäßen Kabelprüfung oder Kabeldiagnose besteht in einer bevorzugten Ausführungsform aus einem Signalgenerator, einer Frequenzweiche zum Einschleusen des Prüf- bzw. Diagnosesignals, Anschlussklemmen bzw. Anschlusssteckern zur Kontaktierung des Prüflings, einem Datenlogger zur Aufzeichnung relevanter Daten, insbesondere des HF-Widerstandes, zumindest einer Messwert-Anzeigevorrichtung, bevorzugt optisch oder akustisch arbeitend, und einer Schnittstelle zur Anbindung der Vorrichtung an ein Netzwerk, einen Back-Up-Rechner oder ähnliches. Weitere bevorzugte Ausführungsformen der Vorrichtung, können, orientiert am gewünschten Prüfungs- oder Diagnoseumfang, mit weniger oder auch mit mehr Funktionen ausgestattet sein.

Die Vorrichtungskomponenten können, zur flexiblen Durchführung von in-situ Diagnosen oder Prüfungen, in einer transportablen Ausführungsform mit eigener Energieversorgung, beispielsweise über Batterien oder Akkus bereitgestellt werden. Für eine parallele Durchführung eines erfindungsgemäßen Messverfahrens an mehreren elektrischen Leitern, ist die Vorrichtung mit einer entsprechenden Anzahl von Eingangs- und Ausgangsschnittstellen für die Prüf- bzw. Diagnosesignale auszustatten.

Nachfolgend wird die Erfindung anhand der aufgeführten Zeichnungen ausführlich erläutert.

Es zeigen
Figur 1 - dem Alphabet nach jeweils eine perspektivische Darstellung von Elektrokabelabschnitten mit schematisch dargestellter von 1A nach 1C zunehmender Oberflächenrauheit der elektrischen Leitung, wozu die Abbildung 1D eine realistische Abbildung zum Vergleich mit dem Zustand aus 1A und die Abbildung 1E zum Vergleich mit 1C bietet, jeweils mit eingetragenem Ausschnitt, welcher jeweilige Ausschnitt in den Figuren 1F (aus 1D) und 1G (aus 1E) vergrößert dargestellt sind,
Figur 2 - eine schematische Detailansicht einer bekannten Gefügeveränderung an der Oberfläche eines elektrischen Leiters durch dynamische mechanische Belastung,
Figur 3 - eine Draufsicht in axialer Richtung auf einen Leiterquerschnitt mit schematisch eingezeichneter Eindringtiefe δ (Skintiefe)eines höherfrequenten elektrischen Stromes, zur besseren Erkennbarkeit ohne die übliche Schnittschraffur,
Figur 4 - eine schematische Ansicht einer Produktionsanlage mit symbolhaft dargestelltem Kabelverlauf und einer in die Anlage integrierten Kabel-Überwachungsvorrichtung,
Figur 5 - ein Diagramm zur Visualisierung eines Signalverlaufs einer beispielhaften Kabelüberwachung nach dem erfindungsgemäßen Verfahren mit einem Sprung der in dBW angegebenen Dämpfung über der Anzahl der Belastungszyklen,
   und
Figur 6 - eine Tabelle zum Verdeutlichen eines Zusammenhanges der Signalfrequenz und der Skintiefe = Eindringtiefe bei der Anwendung des erfindungsgemäßen Verfahrens.

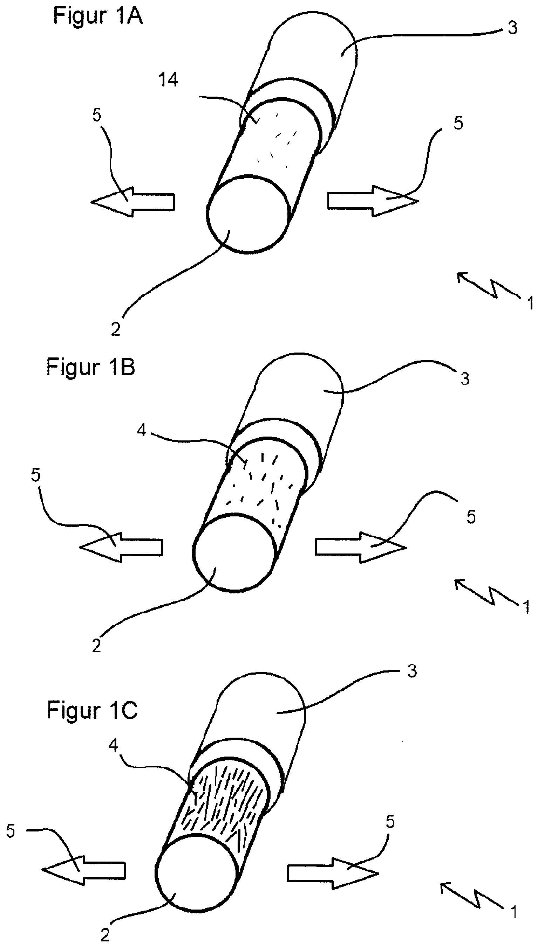

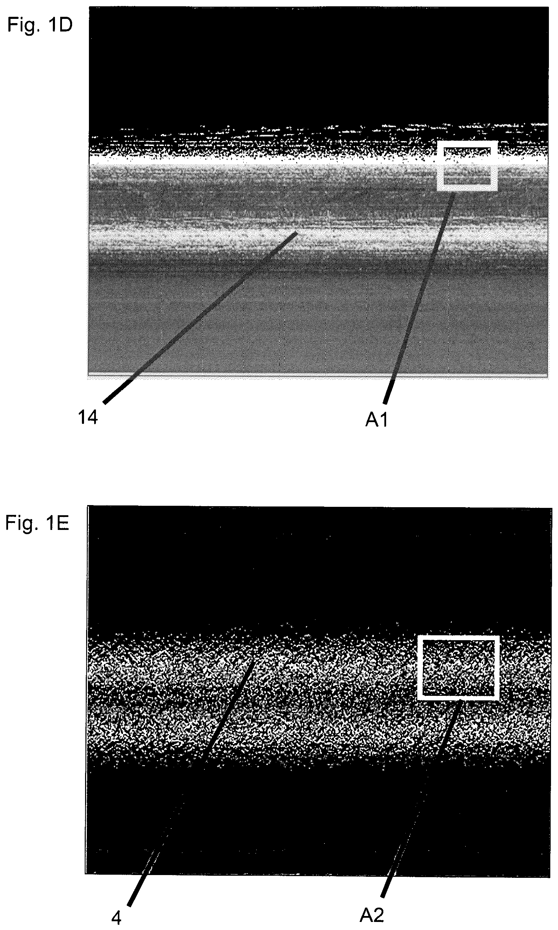

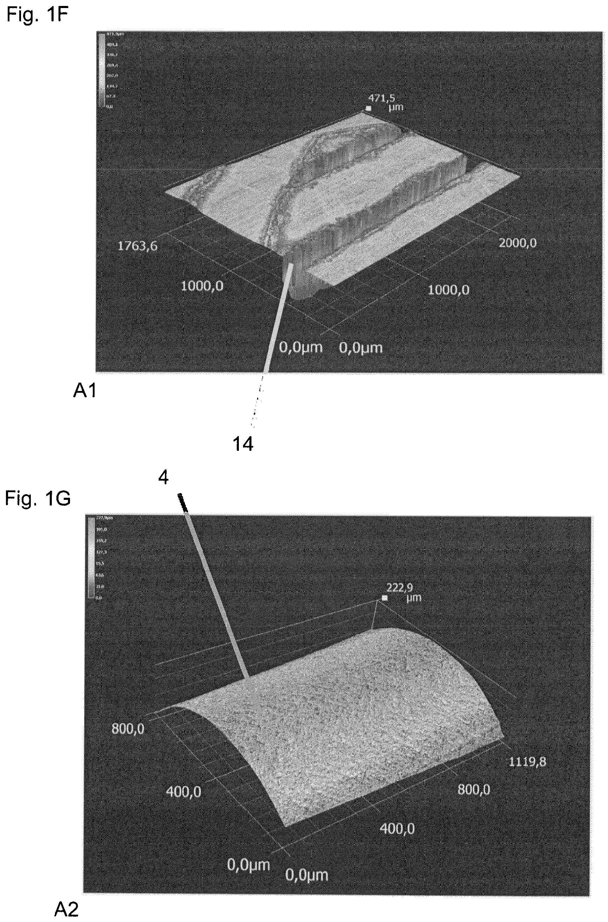

Figur 1 zeigt in Teilfiguren 1A bis 1C jeweils in einer perspektivischen schematischen Ansicht den gedacht immer gleichen Abschnitt eines Elektrokabels 1, wobei dem Alphabet nach von 1A nach 1C die mechanische Belastung des Elektrokabels 1 zunimmt. Das also hier wegen mechanischer Beanspruchung einem Verschleiß unterliegende Elektrokabel 1 ist gemäß einer einfachen Ausführungsform lediglich bestehend aus einem elektrischen Leiter 2, mit üblichen, üblicherweise eher axial ausgerichteten material- und/oder fertigungsbedingten Oberflächenmerkmalen 14, und einer radial außen den Leiter 2 ummantelnden Isolierung 3, dargestellt. Mögliche Biegerichtungen 5 der Elektrokabel 1 durch dynamische mechanische Belastungen sind durch Pfeile angedeutet. Dynamische mechanische Belastungen von metallischen elektrischen Leitern 2 führen, beginnend an der Oberfläche des elektrischen Leiters 2, zu Gefügeveränderungen in der Metallstruktur des elektrischen Leiters 2. Solche Gefügeveränderungen zeigen sich in einer zunehmenden Oberflächenrauheit 4 des elektrischen Leiters 2.

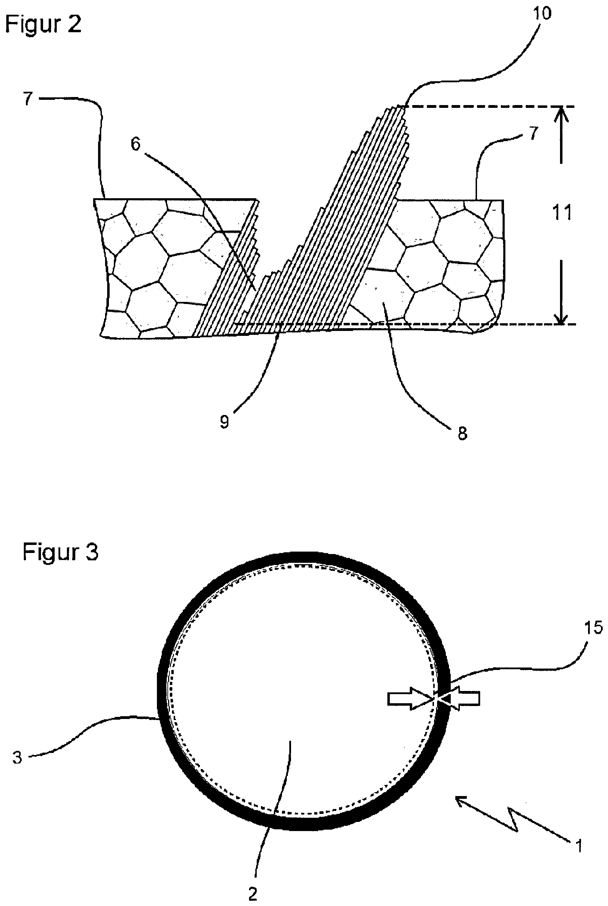

Realistische Bilder solcher Leiter 2 sind den weiteren Teilfiguren 1D bis 1G im paarweisen Vergleich zum Abgleich mit den Schematisierungen gemäß den Figuren 1A uns 1C geeignet. Die realistische Abbildung 1D zeigt im Vergleich mit dem schematisiert dargestellten Zustand aus 1A durchaus ebenfalls eher axial ausgerichtete Vertiefungen. Hier ist eher lokal vereinzelt material- oder fertigungsbedingt eine gewisse Rauheit vorhanden. Es sind in der makroskopischen Aufnahme (Figur 1D) produktionsbedingte Ziehriefen in axialem Verlauf eines fabrikneuen Kupferleiters erkennbar. Figur 1F zeigt einen vergrößerten (mikroskopischen) Ausschnitt des fabrikneuen Leiters und die darin vorhandenen Riefen. Die Dimensionen sind aber nicht repräsentativ. Die Abbildung 1E im Vergleich mit 1C allerdings relativiert die im Verlauf 1A bis 1C angedeutete Häufung solcher Oberflächenveränderungen. Von lokalen fertigungsbedingten Phänomenen eher nicht ausgehend, sondern möglicherweise davon sogar unabhängig, ist nun eher ohne erkennbares Muster bei Betrachtung der Figur 1E mit ihrem vergrößerten Ausschnitt in Figur 1G eine ggf. eine andere Art Rauheit erkennbar, und ggf. sogar darüber hinaus sogar auch im nicht sichtbaren radial äußeren Bereich nahe der Leiteroberfläche 15, welcher in Figur 3 als ein Skintiefenbereich angedeutet ist.

In Figur 1 ist anhand der schematischen Ansichten A - C von Abschnitten eines Elektrokabels 1 die zunehmende Oberflächenrauheit 4 eines elektrischen Leiters also symbolhaft dargestellt.

Figur 2 zeigt in einer schematischen Detailansicht als stark vergrößerten Ausbruch denkbare Veränderungen eines Metallgefüges aufgrund von dynamischer mechanischer Belastung. Das Metallgefüge, bestehend aus Körnern 8, bildet, bei dynamischer mechanischer Belastung, beginnend an einer Oberfläche 7 des Elektrokabels 1, partielle Gefügeveränderungen in Form von Gleitzonen 9 aus. Das Material der Gleitzonen 9 verschiebt sich aufgrund der dynamisch mechanischen Belastung zueinander und bildet dabei als Intrusionen 6 bezeichnete Vertiefungen und als Extrusionen 10 bezeichnete Erhebungen relativ zum umgebenden Material des elektrischen Leiters 2 aus.

Relevant für eine Verschleißdiagnose gemäß eines besonderen erfindungsgemäßen Verfahrens ist der mittlere Abstand 11 zwischen den höchsten Punkten der Extrusionen 10 und den tiefsten Punkten der Intrusionen 6 an verschiedenen Stellen über eine gewisse Länge eines zu bewertenden elektrischen Leiters. Beträgt bei einem metallischen elektrischen Leiter 2 dieser mittlere Abstand 2 µm, hat der betreffende elektrische Leiter 2 ca. 80 % Lebensdauer absolviert und ist damit ablegereif. Es ist mithin also bereits ein erheblicher Verschleiß diagnostiziert und eine aus dem erfindungsgemäßen Verfahren ableitbare Aussage getroffen.

Doch auch für den Fall sich nicht derart gravierend an der Oberfläche äußernden Extrusionen bzw. Intrusionen, wie es eher der Beobachtung Figur 1G entspricht, erlaubt ein erfindungsgemäßes Verfahren zur Beurteilung der Oberfläche bzw. des oberflächennahen Umfangsbereichs als Erfindungserfolg einen Schluss auf einen Kabelverschleißgrad.

Figur 3 zeigt in einer schematischen Querschnittansicht das Elektrokabel 1. Erkennbar dargestellt sind radial innen der elektrische Leiter 2 und eine denselben umgebende Isolierung 3. Eine umlaufende gestrichelte Linie im radial äußeren Bereich des Umfanges des elektrischen Leiters deutet eine Skintiefe 15 an. Wechselströme konzentrieren sich bekanntermaßen, abhängig von ihrer Frequenz, in einem bestimmten Bereich entlang der Oberfläche des elektrischen Leiters 2. Der Wert für die Dicke bzw. Tiefe des durchflossenen Bereiches, gemessen von der Oberfläche des elektrischen Leiters 2 radial zur Mitte hin, wird als Skintiefe 15 bezeichnet. Das erfindungsgemäße Verfahren nutzt besonders bevorzugt Wechselströme mit einer Frequenz von 800 bis 1000 MHz, die eine Skintiefe von ca. 2 µm erreichen und damit gemäß einer Vielzahl von der Erfindung zugrundeliegenden Versuchen einen für eine erfindungsgemäße Verschleißdiagnose relevanten Oberflächenbereich eines elektrischen Leiters 2 abdecken.

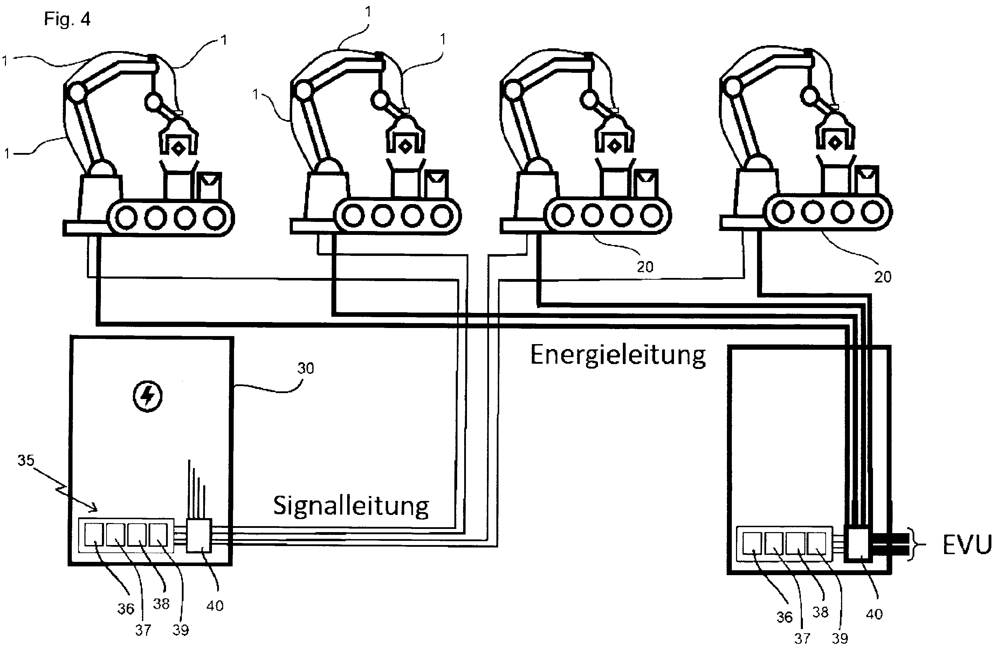

Figur 4 zeigt in einer schematischen Ansicht eine beispielhafte Produktionsanlage und darin integriert, eine erste besonders bevorzugte Ausführungsform einer erfindungsgemäßen Vorrichtung zur Messung des mechanischen Verschleißzustandes von Elektrokabeln 1. Symbolisch dargestellt sind Anlagenkomponenten 20 mit beispielsweise einem Schaltschrank 30 und diese verbindende Elektrokabel 1.

In der in Figur 4 dargestellten Ausführungsform besteht die erfindungsgemäße Vorrichtung aus einem Messgerät 35 mit einer Schnittstelle 40 zur Verbindung einer Elektronik mit mehreren zu überwachenden Elektrokabeln 1.

Die Elektrokabel 1 sind dabei nur schematisch zur Verdeutlichung des Funktionsprinzips eingezeichnet und stellen keine Einschränkung der Anwendbarkeit des erfindungsgemäßen Verfahrens oder der erfindungsgemäßen Vorrichtung dar.

Das Messgerät 35 beinhaltet als Elektronik in der gezeigten Ausführungsform eine Energieversorgung 36, einen Signalgenerator 37, eine Signalauswertung 38 und einen Datenlogger 39. Nicht sichtbar in Figur 4 dargestellt, aber dennoch Bestandteil des bevorzugten Messgerätes sind akustische oder optische Anzeigekomponenten wie beispielsweise ein Bildschirm und zumindest einer Verbindungsmöglichkeit mit externen Vorrichtungen wie beispielsweise einem Netzwerk, einer Maschinensteuerung, einem Back-Up-Rechner.

Das Messgerät 35 ist in der in Figur 4 dargestellten Ausführungsform als stationärer Bestandteil in einen Schaltschrank 30 integriert. In einer zweiten bevorzugten, allerdings nicht dargestellten Ausführungsform, ist das Messgerät 35 als mobile Einheit ohne eigenen Schaltschrank ausgeführt. Die Energieversorgung eines solchen mobilen Messgerätes kann dabei entweder kabelgebunden, über Batterien, Akkus oder weitere geeignete Verfahren wie beispielsweise Induktion erfolgen.

Nicht dargestellt sind weitere bevorzugte Ausführungsformen eines erfindungsgemäßen Messgerätes, die abhängig vom erforderlichen Funktionsumfang, über weniger Komponenten bzw. Funktionen verfügen können. Beispielsweise könnte bei einer turnusmäßigen Überwachung eines Elektrokabels 1 auf einen Datenlogger verzichtet werden, da die Messwerterfassung in diesem Fall manuell geschehen kann. Ebenso denkbar sind weitere Ausführungsformen eines erfindungsgemäßen Messgerätes 35 mit zusätzlichen Funktionen. Zur Verbindung des Messgerätes 35 mit den Elektrokabeln 1, gleichfalls Signalleitungen 31 oder Energieleitungen 32, die einer erfindungsgemäßen Verschleißüberwachung unterzogen werden, ist in Figur 4 die Schnittstelle 40 dargestellt. Die Schnittstelle 40 wird in einer besonders bevorzugten Ausführungsform durch Frequenzweichen zum Einschleusen der Prüf- bzw. Diagnosesignale in die Elektrokabel 1, 31, 32 und Anschlussklemmen oder Steckverbindungen zur bevorzugt trennbaren physischen Verbindung der Elektrokabel 1, 31, 32 mit dem Messgerät 35 gebildet. Die erfindungsgemäße Vorrichtung kann damit auch an bereits im Betrieb befindlichen Anlagen nachgerüstet werden. Mehrere erfindungsgemäße Verfahren können oft in-situ angewendet werden. Die Elektrokabel 1, 31, 32 brauchen zum Anschluss eines Messgerätes 35 nicht von der Anlage getrennt oder stromlos geschaltet werden. Die für eine Überwachung oder Diagnose einzuleitenden Prüf- bzw. Diagnosesignale stören die Stromflüsse von Energie- 32 oder Datenleitungen 31 nicht. Überwachungen und Diagnosen können im laufenden Betrieb der betreffenden Elektrokabel 1, 31, 32 durchgeführt werden.

In der gezeigten ersten besonders bevorzugten Ausführungsform nach Figur 4 wird ein zu überwachendes Elektrokabel 1, 31, 32 über die Schnittstelle 40 mit dem Messgerät 35 verbunden. In der hier nicht dargestellten dritten besonders bevorzugten Ausführungsform wird ein zu überwachendes Elektrokabel 1 über eine Schnittstelle am Kabelanfang zur Einspeisung des Prüf- bzw. Diagnosesignals von einem Signalgenerator eines Messgerätes und am Kabelende mit einer weiteren Schnittstelle zur Ausschleusung eines Ausgangssignals in eine Signalauswertung eines Messgerätes ausgestattet.

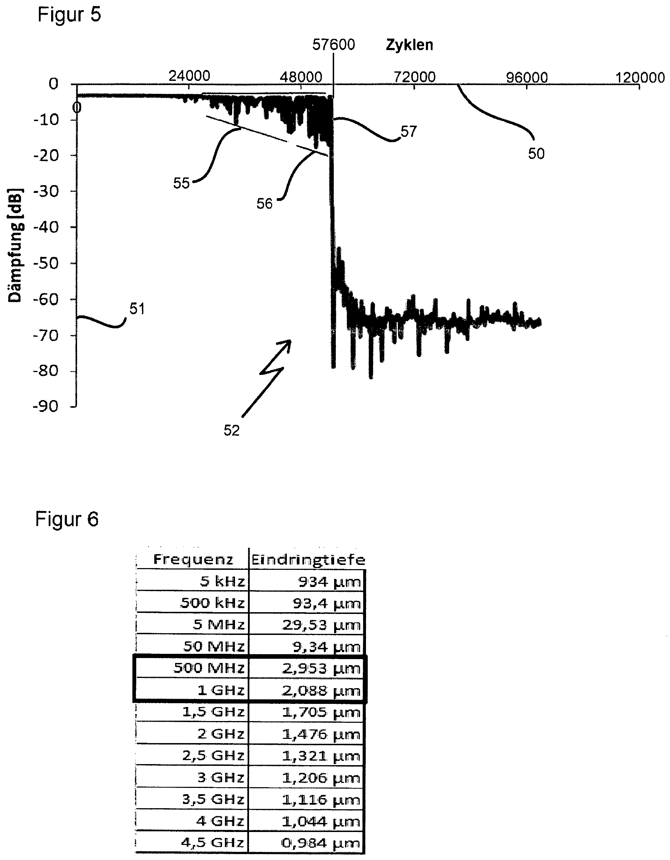

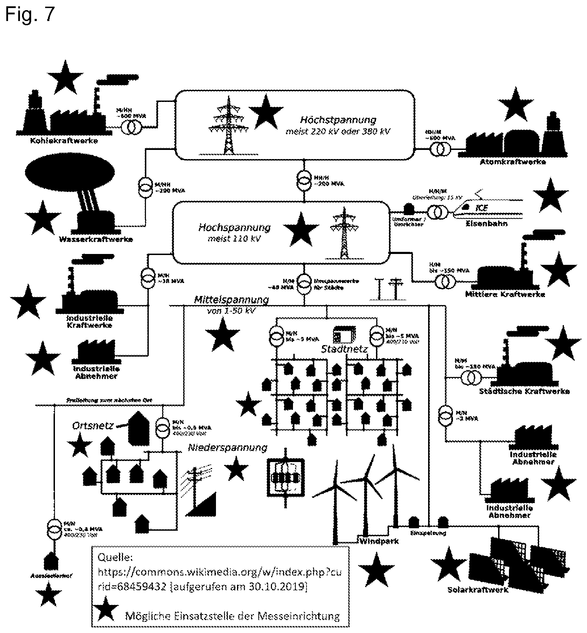

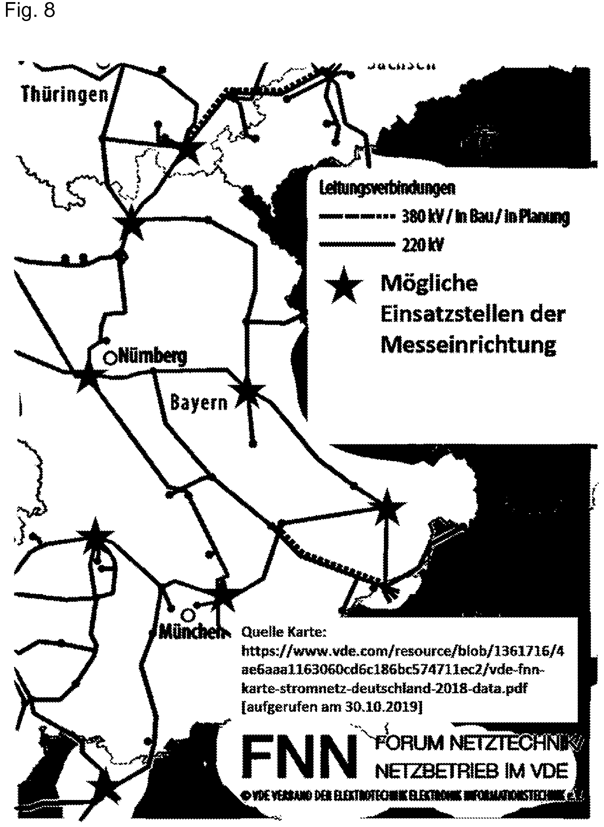

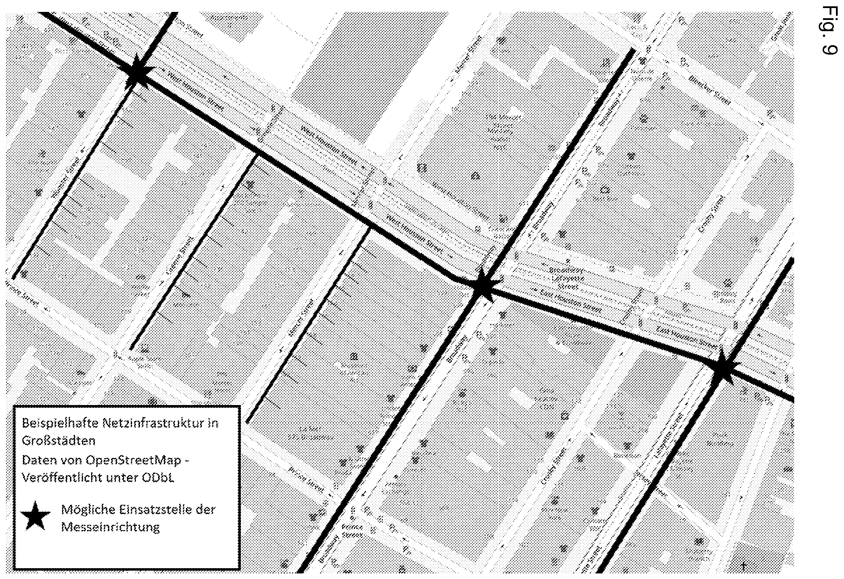

Figur 5 zeigt in Diagrammform den Signalverlauf eines erfindungsgemäßen Prüfsignals in einer beispielhaften Verschleißüberwachung eines Elektrokabels 1. Die Abszisse 50 des Diagramms bildet die Bewegungszyklen einer dynamisch mechanischen Belastung des überwachten Elektrokabels 1 ab. Die Ordinate zeigt die ermittelten Messwerte in dBW resultierend aus der Auswertung des Prüfsignals. Die Auswertung des Prüfsignals geschieht über einen Vergleich des in das Elektrokabel 1 eingespeisten Eingangssignals und des aus dem Elektrokabel 1 austretenden Ausgangssignals. Die Minderung des Signalpegels des Ausgangssignals zum Eingangssignal wird als Dämpfung des Leistungspegels oder Leistungsdämpfung bezeichnet und in Dezibel (dB) angegeben. Sie ist als das Verhältnis von einer ersten Leistung P1 (Eingangssignal) zu einer zweiten Leistung P2 (Ausgangssignal) im Logarithmus zur Basis 10 beschrieben. Damit ist die Leistungsdämpfung eine relative und dimensionlose Größe.

Anhand der Messwertkurve 52 erkennbar dargestellt, ist ein von ca. 24000 bis ca. 48000 Bewegungszyklen verlaufender Bereich einer zunehmenden Schädigung 55, also eines Verschleißes des überwachten Elektrokabels 1.

Ab ca. 48000 Bewegungszyklen signalisiert die Messwertkurve 52 mit weiter steigenden negativen Messwerten die Ablegereife 56 des verschleißüberwachten Elektrokabels 1. Bei 57600 Bewegungszyklen zeigt die Messwertkurve 52 durch eine drastische Veränderung (Zäsur) der Messwerte den Bruch 57 des Elektrokabels 1 an.

Figur 6 zeigt in Tabellenform die Veränderung der Eindringtiefe / Skintiefe von höherfrequenten Wechselströmen in Abhängigkeit von der Frequenz des Wechselstroms. Erkennbar ist, dass Frequenzen zwischen 500 MHz und 1 GHz Eindringtiefen von etwas mehr als 2 µm ergeben, und somit die für erfindungsgemäße Verschleißüberwachungen relevanten Oberflächenschichten von ca. 2 µm der elektrischen Leiter der zu überwachenden Elektrokabel 1 vollständig erfassen.

In verschiedenen Spannungsebenen des allgemeinen elektrischen Energieversorgungsnetzes mit den daran oft angeschlossenen Erzeugern und Verbrauchern sind mögliche Einsatzstellen erfindungsgemäßer Messeinrichtungen auswählbar. Ein Einsatz ist hier auf jeder Versorgungsebene möglich. Zusätzlich findet das System in allen Netzen der Erzeuger und Verbraucher Anwendung. Je nach Anwendung sind verschiedene Einkopplungsmechanismen für das Messsignal realisierbar. Eine direkte, galvanische Verbindung und/oder kapazitiv und induktiv arbeitende Vorrichtungen werden zur erfindungsgemäßen Einkopplung von Messignalen entwickelt.

In dem europäischen Verbundnetz der Hoch- und Höchstspannungsebene oder in einer Großstadtnetzinfrastruktur kommt die erfindungsgemäße Verschleißzustandsmessvorrichtung an strategisch wichtigen Knotenpunkten des Netzes zur Überwachung der Leitungen zum Einsatz.

### Bezugszeichenliste

- 1: Elektrokabel
- 2: elektrischer Leiter
- 3: Isolierung
- 4: Oberflächenrauheit
- 5: Biegerichtung
- 6: Intrusion
- 7: Oberfläche
- 8: Korn
- 9: Gleitzone
- 10: Extrusion
- 11: mittlerer Abstand
- 14: material- und/oder fertigungsbedingtes Oberflächenmerkmal
- 15: Skintiefe
- 20: Anlagenkomponente
- 30: Schaltschrank
- 31: Signalleitung
- 32: Energieleitung
- 35: Messgerät
- 36: Energieversorgung
- 37: Signalgenerator
- 38: Signalauswertung
- 39: Datenlogger
- 40: Schnittstelle

- 50: Abszisse
- 51: Ordinate
- 52: Messwertkurve
- 55: Bereich zunehmende Schädigung
- 56: Bereich Ablegereife
- 57: Kabelbruch

- A1: vergrößerter Ausschnitt
- A2: vergrößerter Ausschnitt

## Patentansprüche

1. Kabelverschleißzustandsmessverfahren zur Bestimmung des Kabelverschleißes,
**dadurch gekennzeichnet,**
**dass** zur Bestimmung des Verschleißes eines Kabels (1) zumindest ein metallischer Leiter (2) des nicht notwendigerweise isolierten Kabels, bei abschnittsweiser Abisolierung oder ohne Abisolierung in einer von der Messung betroffenen Kabelstrecke oder an einem Kabelmesspunkt, in Bezug auf zumindest einer seiner Oberflächeneigenschaften oder in Bezug auf Eigenschaften radial äußerer Leitereigenschaften vermessen wird.

2. Kabelverschleißzustandsmessverfahren nach Anspruch 1, **dadurch gekennzeichnet, dass** die Veränderung der Oberflächenrauheit zumindest eines Abschnitts des zumindest einen elektrischen Leiters über der Zeit aufgezeichnet wird.

3. Kabelverschleißzustandsmessverfahren
nach Anspruch 1 oder 2,
**dadurch gekennzeichnet, dass** als Messsignal ein Wechselstrom verwendet wird, dessen Frequenz derart bestimmt ist, dass unter Nutzung des Skineffektes das Messsignal ausschließlich oder zumindest überwiegend die von einem Verschleiß betroffenen Oberflächenbereiche des zu prüfenden elektrischen Leiters durchfließt, und dass anhand der Auswertung der Impedanzwerte eine Angabe zum Verschleißgrad des elektrischen Leiters getroffen wird.

4. Kabelverschleißzustandsmessverfahren nach Anspruch 3, **dadurch gekennzeichnet, dass** die Skintiefe im Fall eines Kupferleiters etwa 2 µm beträgt und das Messsignal eine Frequenz etwa 800 bis 1000 MHz aufweist.

5. Kabelverschleißzustandsmessverfahren
nach einem der vorangehenden Ansprüche,
**dadurch gekennzeichnet, dass** ein Widerstandswert eines von elektrischem Messstrom durchflossenen Kabelabschnittes gemessen wird.

6. Kabelverschleißzustandsmessverfahren
nach einem der vorangehenden Ansprüche, **dadurch gekennzeichnet, dass** die Stromstärke des Prüfsignals im Milliampere-Bereich liegt.

7. Kabelverschleißzustandsmessvorrichtung zur Durchführung eines Verfahrens nach einem der Ansprüche 1 bis 6.

8. Kabelverschleißzustandsmessvorrichtung nach Anspruch 7, **dadurch gekennzeichnet, dass** ein Signalgenerator (37) und ein Impedanzmessgerät elektrisch mit dem in Bezug auf die Oberflächenrauheit zu beurteilenden elektrischen Leiter verbunden sind.

9. Kabelverschleißzustandsmessvorrichtung
nach Anspruch 7 oder 8,
**dadurch gekennzeichnet, dass** eine der Vorrichtung eigene Energieversorgungseinheit (36) eine Verwendung als transportable Messvorrichtung gestattet.

10. Verwendung eines Messgeräts (35)
nach einem der Ansprüche 7-9, welches die Oberfläche oder einen radial äußeren Materialbereich nahe der Oberfläche zumindest eines in einem Kabel verlaufenden Leiters untersucht, zur Bestimmung eines Verschleißzustands des Kabels.

## Claims

1. Cable state of wear measuring method for determining cable wear,
**characterized**
**in that**, in order to determine the wear of a cable (1), at least one metallic conductor (2) of the cable, which is not necessarily insulated, is measured in the case of section-by-section stripping or without stripping in a cable section affected by the measurement or at a cable measuring point with respect to at least one of its surface properties or with respect to properties of radially external conductor properties.

2. Cable state of wear measuring method according to Claim 1,
**characterized in that** the change in the surface roughness of at least one portion of the at least one electrical conductor is recorded over time.

3. Cable state of wear measuring method
according to Claim 1 or 2,
**characterized in that** an alternating current is used as a measuring signal, the frequency of which is determined such that, using the skin effect, the measuring signal flows exclusively or at least predominantly through the surface areas of the electrical conductor to be tested that are affected by wear, and that an indication of the degree of wear of the electrical conductor is made on the basis of the evaluation of the impedance values.

4. Cable state of wear measuring method according to Claim 3,
**characterized in that** the skin depth in the case of a copper conductor is about 2 µm and the measuring signal has a frequency of about 800 to 1000 MHz.

5. Cable state of wear measuring method
according to any one of the preceding claims, **characterized in that** a resistance value of a cable portion through which electrical measuring current flows is measured.

6. Cable state of wear measuring method
according to any one of the preceding claims, **characterized in that** the current intensity of the test signal is in the milliampere range.

7. Cable state of wear measuring device for carrying out a method according to any one of Claims 1 to 6.

8. Cable state of wear measuring device according to Claim 7,
**characterized in that** a signal generator (37) and an impedance measuring unit are electrically connected to the electrical conductor to be assessed with respect to the surface roughness.

9. Cable state of wear measuring device
according to Claim 7 or 8,
**characterized by** its own energy supply unit (36) ,which allows it to be used as a transportable measuring device.

10. Use of a measuring unit (35) according to any one of Claims 7-9, which examines the surface or a radially outer material region near the surface of at least one conductor running in a cable in order to determine a state of wear of the cable.

## Revendications

1. Procédé de mesure de l'état d'usure d'un câble pour déterminer l'usure d'un câble,
**caractérisé en ce que**
pour déterminer l'usure d'un câble (1), on mesure au moins un conducteur métallique (2) du câble non nécessairement isolé, dénudé localement ou non dénudé dans un tronçon de câble soumis à la mesure ou en un point de mesure du câble, pour savoir au moins l'une de ses propriétés de surface ou pour savoir les propriétés radialement extérieures du conducteur.

2. Procédé de mesure de l'état d'usure d'un câble selon la revendication 1, **caractérisé en ce que**
on enregistre la variation de la rugosité de surface d'au moins une partie dudit au moins un conducteur électrique en fonction du temps.

3. Procédé de mesure de l'état d'usure d'un câble selon la revendication 1 ou 2,
**caractérisé en ce que**
on utilise comme signal de mesure un courant alternatif dont la fréquence est déterminée de telle sorte que, en utilisant l'effet de peau, le signal de mesure traverse exclusivement ou au moins principalement les zones de surface du conducteur électrique à contrôler qui sont affectées par une usure, et
**en ce que**, à l'aide de l'évaluation des valeurs d'impédance, on donne une information sur le degré d'usure du conducteur électrique.

4. Procédé de mesure de l'état d'usure d'un câble selon la revendication 3, **caractérisé en ce que**
la profondeur de peau est d'environ 2 µm dans le cas d'un conducteur en cuivre, et le signal de mesure a une fréquence d'environ 800 à 1000 MHz.

5. Procédé de mesure de l'état d'usure d'un câble selon l'une des revendications précédentes,
**caractérisé en ce que**
on mesure une valeur de résistance d'un tronçon de câble traversé par un courant électrique de mesure.

6. Procédé de mesure de l'état d'usure d'un câble selon l'une des revendications précédentes,
**caractérisé en ce que**
l'intensité du courant du signal de contrôle est de l'ordre du milliampère.

7. Dispositif de mesure de l'état d'usure d'un câble pour mettre en œuvre un procédé selon l'une des revendications 1 à 6.

8. Dispositif de mesure de l'état d'usure d'un câble selon la revendication 7, **caractérisé en ce que**
un générateur de signal (37) et un impédancemètre sont reliés électriquement au conducteur électrique à évaluer en termes de rugosité de surface.

9. Dispositif de mesure de l'état d'usure d'un câble selon la revendication 7 ou 8,
**caractérisé en ce que**
une unité d'alimentation en énergie (36) propre au dispositif permet une utilisation comme dispositif de mesure transportable.

10. Utilisation d'un dispositif de mesure (35) selon l'une des revendication 7 à 9, lequel examine la surface ou une zone de matériau radialement extérieure proche de la surface d'au moins un conducteur s'étendant dans un câble, pour déterminer un état d'usure du câble.
